# EUROPÄISCHE PATENTSCHRIFT

(11) **EP 1 224 476 B1**
(45) Veröffentlichungstag und Bekanntmachung des Hinweises auf die Patenterteilung: **05.11.2003**
(21) Anmeldenummer: 00964113.5
(22) Anmeldetag: 05.09.2000
(51) Int. Cl.: G01R 1/067, G01R 1/073

(54) **PRÜFSTIFT FÜR EINE VORRICHTUNG ZUM TESTEN VON LEITERPLATTEN**
TEST PROBE FOR A DEVICE FOR TESTING PRINTED CIRCUIT BOARDS
BROCHE D'ESSAI POUR DISPOSITIF SERVANT A TESTER LES PLAQUETTES A CIRCUITS IMPRIMES

(30) Priorität: 26.10.1999 DE 19951501
(43) Veröffentlichungstag der Anmeldung: 24.07.2002
(73) Patentinhaber: atg test systems GmbH & Co. KG, 97877 Wertheim (DE); Ott, Bernd, 74405 Gaildorf (DE); Prokopp, Manfred, 97877 Wertheim (DE)
(72) Erfinder: OTT, Bernd, 74405 Gaildorf (DE); PROKOPP, Manfred, 97877 Wertheim-Reicholzheim (DE)
(74) Vertreter: Ganahl, Bernhard
(86) Internationale Anmeldenummer: EP0008670
(87) Internationale Veröffentlichungsnummer: WO01031348

(56) Entgegenhaltungen:
- DE-A- 3 426 295
- DE-A- 3 643 305
- US-A- 4 633 176
- US-A- 4 896 107
- RUDD R: "SMD-TECHNIK VERAENDERT PRUEFMITTEL" FEINWERKTECHNIK + MESSTECHNIK,DE,CARL HANSER VERLAG. MUNCHEN., Bd. 98, Nr. 7 / 08, 1. August 1990 (1990-08-01), Seiten 317-318, XP000149228

## Beschreibung

Die vorliegende Erfindung betrifft einen Prüfstift für eine Vorrichtung zum Testen von Leiterplatten sowie einen Adapter und eine Vorrichtung zum Testen von Leiterplatten.

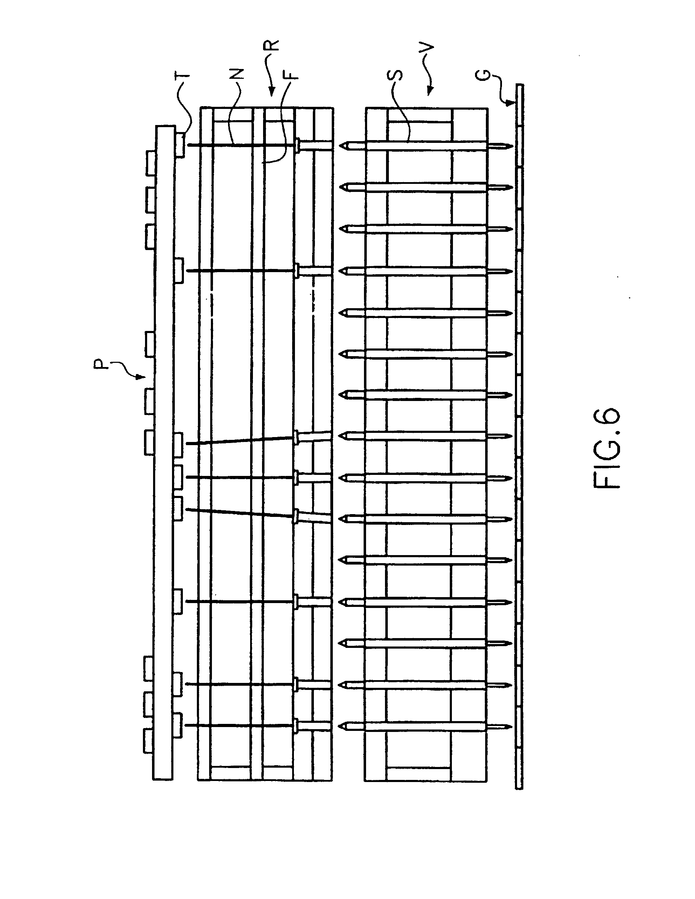

Aus dem Stand der Technik sind diverse Bauformen von Prüfstiften oder Prüfnadeln zum Einsatz in Vorrichtung zum Testen von Leiterplatten bekannt. Eine Vorrichtung nach dem Stand der Technik ist in Fig. 6 gezeigt. Mit einem Rasteranpassungsadapter R wird ein vorbestimmtes, regelmäßiges Grundraster eines Grundrasterfeldes G auf die üblicherweise unregelmäßige Anordnung der Leiterplattentestpunkte T einer zu testenden Leiterplatte P umgesetzt. Der Rasteranpassungsadapter R weist in der Regel mehrere voneinander beabstandete Führungslagen F auf, in welchen Führungslöcher zur Aufnahme der Prüfnadeln N eingebracht sind. Die Prüfnadeln N sind in dem Adapter R starr und schräg angeordnet, so daß sie Kontaktpunkte des regelmäßigen Grundrasters mit den Leiterplattentestpunkten T elektrisch verbinden können, da diese von der regelmäßigen Anordnung des Grundrasters abweichen.

Für den Ausgleich von Unebenheiten der Leiterplattentestpunkte der zu prüfenden Leiterplatte und für eine elektrisch sichere Kontaktierung mit dem Grundrasterfeld G steht der Rasteranpassungsadapter R mit einer Vollrasterkassette V in Verbindung, die mit federnden Prüfstiften S in dem jeweiligen Raster des Grundrasterfeldes bestückt ist. Die Vollrasterkassette ist vollständig mit Stiften besetzt, während der Rasteranpassungsadapter üblicherweise nur so viele Nadeln N aufweist, wie die zu prüfende Leiterplatte Leiterplattentestpunkte T aufweist. Die Bauformen der Nadeln N sind üblicherweise stabförmig und tragen meist Absätze oder endseitige Verdickungen, wie u.a. in EP 0 149 776 B2 und DE G 90 14 236.5 U1 offenbart.

Moderne Leiterplatten weisen zahlreiche interne Verdrahtungsebenen auf oder sind zur direkten Aufnahme von hoch integrierten ICs vorgesehen. Insbesondere durch den Einsatz hochdichter Anordnungen von Anschlußflächen, wie zum Beispiel von Ball Grid Arrays (BGA), sind die Anforderungen an die Zahl der zu kontaktierenden und zu messenden Kontaktpunkte an einer Leiterplatte erheblich gestiegen. Zugleich ist der Zwischenkontaktabstand bei derartigen Leiterplatten bis auf ca. 0,25 mm (10 mit) abgesunken. Für derartige Adapter in diesem Einsatzfeld verwendet man deshalb extrem dünne Nadeln, die beispielsweise nur einen Durchmesser von 0,1 mm oder 0,2 mm aufweisen. Diese Nadeln sind aber äußerst instabil, so daß viele Führungslagen im Adapter vorgesehen werden müssen, um sie sicher führen zu können. Der Aufwand zur Herstellung einer Prüfvorrichtung, die für jede Bauart zu prüfender Leiterplatten individuell anzufertigen ist, ist aufgrund der genannten Anforderungen sehr hoch.

Im Artikel: "SMD-Technik verändert Prüfmittel" aus Feinwerktechnik & Messtechnik 98, No. 7/8, Seiten 317-318 ist ein Kontaktstift für SMD-bestückte Leiterplatten offenbart, der eine Stifthülse aufweist und einen in der Stifthülse verschieblichen Kolben besitzt. Der Durchmesser des Kolbens beträgt 1,3 mm. Hierin werden Stifte mit geringer Wandstärke der Stifthülse und mit geringem Schaftdurchmesser des Kolbens als nachteilig beschrieben.

Die US 4,4,896,107zeigt Kontaktstifte mit konisch zulaufenden Spitzen. Diese Kontaktstifte weisen im Bereich des Schaftes eine maximale Dicke von 1,3-1,4 mm auf, wobei der an dem Kontaktstift ausgebildete Kopf einen Durchmesser von 2 mm besitzt.

Die DE 36 43 305 A1 zeigt einen Federkontaktstift mit einem langgestreckten metallischen Zylinder, der als Hülse dient und ein einstückiges metallisches Rohr-Schrauben-Feder-Teil aufweist, das in der Hülse eingesetzt ist und einen in der Hülse verschieblichen Kontaktstift bildet.

Ein weiterer Kontaktstift geht aus der DE 34 26 295 A1 hervor. Dieser Kontaktstift weist wiederum eine Hülse und einen Kolben auf. Der Kolben ist mit einer Abflachung versehen, in die eine Quetschnut der Hülse eingreift. Das Vorsehen einer solchen Kontur zeigt, dass der hierbei verwendete Kolben wesentlich dicker als die erfindungsgemäße Nadel ist.

Die US 4,633,176 betrifft einen Adapter zum Testen von Leiterplatten, in dem seitlich auslenkbare Prüfstifte vorgesehen sind, die mittels einer konischen Spitze und mit der konischen Spitze zusammenwirkenden Bohrungen ausgelenkt und auf vorbestimmte Kontaktstellen der zu prüfenden Leiterplatte ausgerichtet werden.

Der Erfindung liegt die Aufgabe zugrunde, einen Prüfstift zu schaffen, der den Anforderungen an immer weiter wachsenden Anzahl, eng aneinander liegend angeordneter Anschlußflächen beim Messen bzw. Kontaktieren moderner Leiterplatte gerecht wird. Ferner besteht die Aufgabe, einen Adapter und eine verbesserte Vorrichtung zum Testen von Leiterplatten zu schaffen.

Die Erfindung weist zur Lösung dieser Aufgaben einen Prüfstift mit den Merkmalen des Anspruchs 1 sowie einen Adapter mit den Merkmalen des Anspruchs 11 und eine Vorrichtung zum Testen von Leiterplatten mit den Merkmalen des Anspruchs 14 auf. Vorteilhafte Ausgestaltungen hiervon sind Gegenstand der jeweiligen Unteransprüche.

Ein erfindungsgemäßer Prüfstift für eine Vorrichtung zum Testen von Leiterplatten zeichnet sich dadurch aus, daß er eine Nadel und eine Hülse umfaßt, wobei die Nadel in der Hülse verschieblich geführt ist und die Nadel mindestens 10 mm aus der Hülse herausragt, insbesondere mehr als 20 mm. Die Nadel verjüngt sich an dem aus der Hülse herausragenden Bereich konisch bis zu einer Kontaktspitze.

Dieser vorstehende, sich konisch verjüngende Bereich des Kontaktstiftes erlaubt eine sehr dichte Positionierung der Kontaktstifte im Bereich ihrer Kontaktspitzen, da der Kontaktstift in diesem Bereich durch die konisch zulaufende Spitze eine sehr geringe Dicke aufweist.

Durch die Führung der Nadel in der Hülse wird eine verbesserte Eigensteifigkeit bei gleichzeitiger federnder Ausgleichsfähigkeit des Prüfstifts geschaffen. Weiter weist ein erfindungsgemäßer Prüfstift eine gute Integrationsfähigkeit in Adaptern zum Abtasten sehr dichter Kontaktflächenanordnungen mit geringen Abständen zwischen den Kontaktflächen aus.

Diese Kombination einer sich zur Kontaktspitze verjüngenden Nadel und einer Hülse, aus welcher die Nadel ein beträchtliches Stück hervor steht, erlaubt somit ein dichtes Anordnen mehrerer Prüfstifte im Bereich ihrer Kontaktspitzen, weist die notwendige Steifheit auf und ist einfach ausgebildet.

Weiter besteht ein erfindungsgemäßer Adapter aus mindestens zwei parallelen Lagen, in denen federnde Prüfstifte der vorstehend genannten Art in durchgehenden Ausnehmungen gelagert sind, wobei die Prüfstifte teilweise schräg angeordnet sind und Kontaktspitzen der Prüfstifte zur Kontaktierung eines Prüflings herausragen sowie die Prüfstifte an einer dem Prüfling gegenüberliegenden Seite des Adapters zur Kontaktierung eines regelmäßig mit Kontakten versehen Grundrasterfeldes ausgebildet sind. Damit wird durch einen erfindungsgemäßen Adapter die Zweiteilung in eine Vollrasterkassette mit federnden Stiften und einem Starrnadeladapter zur Anpassung von einem regelmäßigen Raster üblicher Grundrasterfelder hin zu einem beliebigen Raster eines Prüflings aufgehoben. Hier übernimmt die Hülse wesentliche Stütz- und Führungsaufgaben, so daß die Zahl der inneren Lagen gering gehalten werden kann. In Adaptern muß das Lochraster jeder Lage einzeln durch Computer berechnet und durch hochpräzise CNC-Maschinen mit einem gebohrtem Lochraster erstellt werden, so daß jede Einsparung einer Lage einen beträchtliche Kostensenkung mit sich bringt. Insgesamt wird durch die vorliegende Erfindung ein einziger und sehr kompakter Adapter bei deutlicher Reduzierung der Einzelteile und entsprechend günstigeren Kosten geschaffen.

Ferner zeichnet sich eine erfindungsgemäße Vorrichtung zum Testen von Leiterplatten durch einen Aufbau mit einem regelmäßigen Grundrasterfeld, einem Adapter mit mehreren Prüfstiften aus, wobei der Adapter an einer ersten Oberseite mit den Prüfstiften in elektrisch leitender Verbindung stehende Kontakte aufweist, die einer Kontaktanordnung auf dem Testfeld angepaßt sind, und an einer zweiten Oberseite die Kontaktspitzen der Prüfstifte herausragen, wobei jede der Kontaktspitzen einem bestimmten Leiterplatten-Prüfpunkt eines Prüflings zugeordnet ist und bei einem in die Vorrichtung eingelegten Prüfling mit dem Leiterplatten-Prüfpunkt eines Prüflings in elektrisch leitender Berührung steht. Diese Vorrichtung ist aus den vorstehend genannten erfindungsgemäßen Komponenten aufgebaut und beinhaltet als geschlossenes System alle vorgenannten Vorteile in sich.

Die vorstehende Aufgabe, die Merkmale und Vorteile nach der vorliegenden Erfindung können unter Berücksichtigung der folgenden, detaillierten Beschreibung der bevorzugten Ausführungsformen der vorliegenden Erfindung und unter Bezugnahme auf die zugehörigen Zeichnungen besser verstanden werden.

Die Erfindung wird im folgenden anhand der Zeichnungen näher erläutert. Diese zeigen in:
- Fig. 1: eine skizzierte Darstellung eines Prüfstiftes in einer ersten Ausführungsform;
- Fig. 2: eine skizzierte Darstellung einer weiteren Ausführungsform eines Prüfstiftes
- Fig. 3: eine skizzierte Darstellung einer weiteren Ausführungsform einer Nadel;
- Fig. 4: eine skizzierte Seitenansicht einer Vorrichtung zum Prüfen mit eingesetzten Prüfling;
- Fig. 5: eine Ausschnittsvergrößerung von Fig. 4 und
- Fig. 6: eine Darstellung einer Prüfvorrichtung nach dem Stand der Technik.

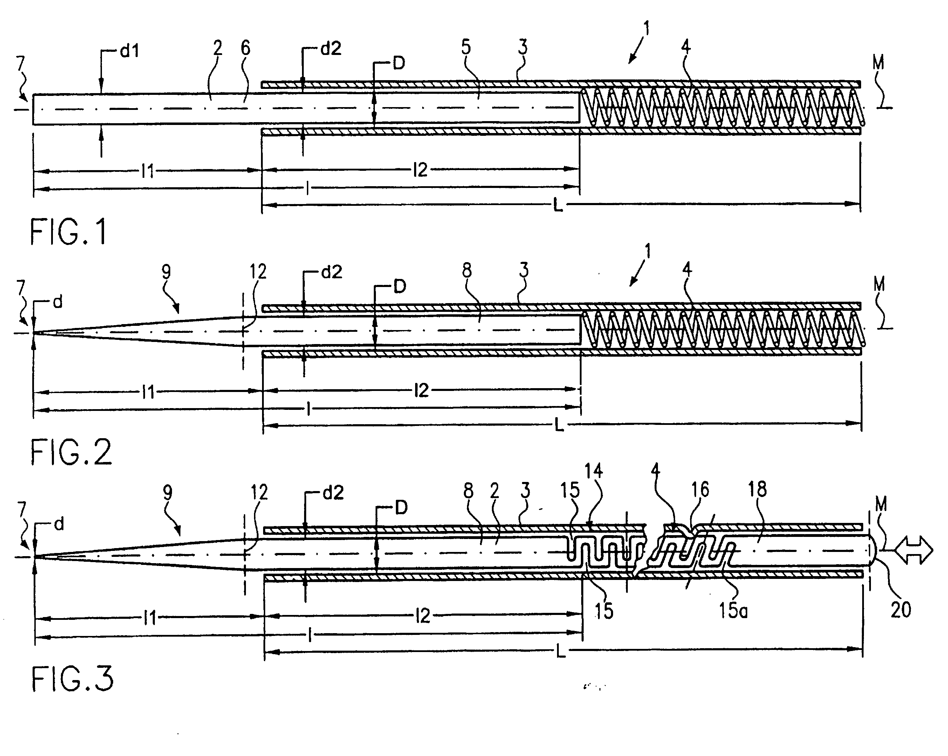

Fig. 1 zeigt einen Prüfstift 1, eine Nadel 2 und eine Hülse 3 mit einer Feder 4 umfasst. Die Nadel 2 weist eine gesamte Länge I von ca. 40 mm bis 70 mm auf, die Hülse eine Länge L von ca. 70 mm bis 100 mm.

Die Nadel 2 ist mit einem Führungsbereich 5 in der Hülse 3 entlang einer Mittelachse M verschieblich gelagert, wobei die Nadel 2 mit einem an den Führungsbereich 5 anschließenden Außenbereich 6 aus der Hülse 3 frei hervorsteht. Der Außenbereich 6 besitzt an einem freien Ende in eine Kontaktspitze 7.

Ein Äußendurchmesser d1 der Nadel 2 beträgt sowohl in dem Außenbereich 6 als auch im Führungsbereich 5 als Außendurchmesser d2 ca. 0,15 bis 0,30 mm und vorzugsweise 0,2 bis 0,25 mm. Dem Außendurchmesser d2 des ;Basisbereichs 6 ist ein Innendurchmesser D der Hülse 3 angepaßt, um eine reibungsarme Verschieblichkeit der Nadel 2 in der Hülse 3 zu gewährleisten und dabei die Steifigkeit der Nadel 2 durch eine Führung durch die Hülse 3 zu erhöhen. Hierdurch ist es möglich dünne Nadeln 2 zu verwenden. Damit können vorstehend beschriebene Prüfstifte 1 in einem Adapter sehr eng angeordnet werden, da der Außenbereich 6, der in an die Kontaktspitze 7 angrenzt, sehr dünn ist und eine Länge 11 von zumindest 10 mm aufweist. Weiter ist die Nadel 2 in dem beschriebenen Prüfstift 1 federnd angeordnet, so daß ein selbständiger Ausgleich von Toleranzen an einem Prüfling gegeben ist. Damit sind die Funktionen der bekannten Starmadeln (dichte Anordnung) und der bekannten Prüfstifte (Federung) in dem Prüfstift vereinigt.

Fig. 2 zeigt ein erstes Ausführungsbeispiel eines erfindungsgemäßen Prüfstiftes 1 mit einer Nadel 2 und einer Hülse 3. Die Nadel 2 weist einen Basisbereich 8 und einen sich daran anschließenden Kontaktbereich 9 auf. Der Basisbereich 8 bildet einen stabförmigen Abschnitt mit kreisförmigen Querschnitt und konstantem Durchmesser d2 und der Kontaktbereich 9 ist zu seinem freien Ende hin konisch verjüngt ausgebildet, so daß er an seinem freien Ende eine Kontaktspitze 7 aufweist. Der Durchmesser d der Kontaktspitze 7 ist kleiner oder gleich 0,2 mm und beträgt vorzugsweise 0,1 mm, damit eng beieinander liegende Leiterplattentestpunkte einer zu prüfenden Leiterplatte kontaktiert werden können. Der der Kontaktspitze 7 gegenüberliegende Endabschnitt 12 des Kontaktbereichs 8 besitzt den gleichen Durchmesser d2 wie der Basisbereich 8, wobei sich der Endabschnitt 12 auch außerhalb der Hülse 3 befinden kann.

Angrenzend an die Nadel 2 ist in der Hülse 3 die Feder 4 angeordnet (Fig. 1 und Fig. 2).

In einem zweiten Ausführungsbeispiel der Erfindung (Fig. 3) ist ein Endabschnitt 14 des Basisbereichs 8 der Nadel 2 durch Lasereinschnitte 15 als Feder 4 ausgebildet. Diese Lasereinschnitte 15 können senkrecht zu der Mittelachse M verlaufen und in einer Ebene verlaufen, wie in der Abbildung von Fig. 3 dargestellt. Durch eine wechselseitige Anordnung der Lasereinschnitte 15 ergibt sich insgesamt eine mäanderförmige Struktur vorbestimmter Federsteifigkeit. Zur Vergrößerung der Federweges wird die Mäander-förmige Struktur in ihrer Länge angepaßt. Die Federsteifigkeit wird auch durch die Materialeigenschaft und die Materialstärke der zwischen den Lasereinschnitten 15 verbleibenden Stege bestimmt. Zur Erhöhung der Federeigenschaften können (in der Abbildung von Fig. 3 angedeutet) die Lasereinschnitte 15a unter einem Winkel < 90° zu der Mittelachse M angeordnet sein.

Nach einer weiteren Ausführungsform wird die Feder unter Drehen der Nadel 2 um die Mittelachse M mit Vorschub beim Lasem gefertigt, so daß eine schraubenförmige Feder 2 mit einstellbarer Ganghöhe und Materialstärke hergestellt wird. Neben einem Laserprozeß sind auch vergleichbare Verfahren bei der Herstellung der Nadel 2 und der Feder 4 entsprechend einsetzbar, wie z.B. Ätzen.

Gegenüber einer separaten Fertigung einer Feder 4 weisen die einstückigen Ausführungsformen von der Nadel 2 und der Feder 4 mehrere Vorteile auf. Zum einen können die Nadeln 2 u.a. in einem Laserverfahren hergestellt werden, so daß in einem Produktionsschritt der Kontaktbereich 2 hergestellt bzw. vergütet und direkt anschließend ohne Einsatz neuer Werkzeuge oder eine Umrüstung mit Rüstzeit die Feder 4 hergestellt werden kann. Es wird somit unter Einsparung von Zusatzmaterialien, Zeit und weiteren Werkzeugen eine einstückige und somit leicht zu handhabende Anordnung aus Nadel 2 und Feder 4 hergestellt. Zudem wird durch die einteilige Ausbildung von Nadel 2 und Feder 4 eine ideale elektrische Verbindung zwischen der Nadel 2 und der Feder 4 hergestellt. Kontakt-Grenzflächen zwischen Nadel 2 und Feder 4 mit ihren Übergangswiderständen werden bei obiger Ausführungsform beseitigt.

Die Feder 4 kann entweder allein oder bei einstückiger Verbindung mit der Nadel 2 zusammen in der Hülse 3 befestigt werden. Dazu wird die Feder 4 vorzugsweise an einem der Kontaktspitze 7 abgewandten Ende der Hülse 3 durch Löten, Schweißen, Quetschen etc. in der Hülse 3 fixiert, wie z.B. in Fig. 1 dargestellt.

Die Feder 4 wird nach einer bevorzugten Ausführungsform bspw. durch eine Einprägung 16 in einem Endbereich derart in der Hülse 3 fixiert, daß sie gegen ein Verschieben bzw. Herausrutschen gesichert ist. Dabei ist die Fixierung vorzugsweise ein Stück entfernt vom Ende der Hülse 3 angeordnet, so daß ein endseitig verbleibender Federabschnitt verbleibt. An diesem Endabschnitt ist ein Endbereich 18 mit einem definiert federnden und insbesondere mit einer balligen außenseitigen Oberfläche ausgeführten Kontaktkörper 20 ausgebildet. Dieser Kontaktkörper 20 bildet auch bei einer nachfolgend noch dargestellten Schrägstellung des Prüfstifts 1 aufgrund der federbelasteten balligen außenseitigen Oberfläche einen stets sicheren elektrischen Kontakt mit einem Kontakt eines Grundrasterfeldes (Fig. 3).

Zum Prüfen einer zu testenden unbestückten Leiterplatte 22 sind die Prüfstifte 1 in einem Adapter 24 (Fig. 3) angeordnet, mit welchem ein regelmäßiges Grundraster einer Prüfvorrichtung bzw. ein Grundrasterfeld 26 auf die unregelmäßige Anordnung der Leiterplatten-Prüfpunkte 28 umgesetzt wird, indem die Prüfstifte 1 im Adapter 24 teilweise schräggestellt sind. Insbesondere ist es mit einem solchen Adapter 24 möglich, daß viele eng beieinander liegende Leiterplatten-Prüfpunkte 28 getestet werden können, indem eine entsprechende Anzahl von Prüfstiften 1, die einen größeren Bereich des Grundrasterfeldes 26 abdecken, auf diesen Bereich der eng beieinander liegenden Leiterplatten-Prüfpunkte 28 gerichtet werden. Diese Prüfstifte 1 sind somit ähnlich wie bei einem Strahlenbündel auf diese eng beieinander liegenden Leiterplatten-Prüfpunkte 28 fokusiert.

Die Prüfstifte 1 werden in dem Adapter 24 durch zwei voneinander in Abständen angeordnete Lagen 30 und einer benachbart zum Prüfling 22 angeordneten Lage 31. gehalten, in welche Führungsbohrungen 32 eingebracht sind, durch die sich die Prüfstifte 1 erstrecken. Die Führungsbohrungen 32 werden durch Bohren Lasern oder Ätzen eingebracht. Die Bohrungen können in Bezug auf eine Ebene der jeweiligen Lage 30, 31 zur Senkrechten abweichende Achsen aufweisen (Fig. 5).

Da die Nadeln 2 der Prüfstifte 1 ein Stück aus der Hülse vorstehen, werden die Ausnehmungen 33 in der zum Prüfling benachbarten Lage 31 lediglich von den dünnen Nadeln 2 und nicht von den Hülsen 3 durchsetzt, weshalb die Nadeln 2 im Bereich der Lage 31 dicht nebeneinander angeordnet werden können.

Grundsätzlich ist jedoch zu berücksichtigen, daß der minimale Abstand zwischen den Kontaktspitzen 7 benachbarter Prüfstifte 1 nicht beliebig verringert werden kann, da die Führungslöcher nicht beliebig eng aneinanderliegend gebohrt werden können und zudem beim Bohren Bohrstege entstehen, die einen gewissen Abstand verursachen. Aufgrund der räumlichen Anordnung der Prüfstifte ist es nicht möglich, relativ dicke Prüfstifte mit lediglich einer kleinen, kurzen Spitze vorzusehen, da diese Nadeln wegen der entsprechend größeren Bohrlöcher nicht eng nebeneinander liegend angeordnet werden können und zudem die Gefahr besteht, daß sie sich mit den an den Kontaktspitzen angrenzenden Bereichen berühren. Bei den erfindungsgemäßen Nadeln werden diese Probleme durch die große Länge I des freien Kontaktbereichs 9, die sich allmählich über eine vorbestimmte Länge I konisch erweitert vermieden.

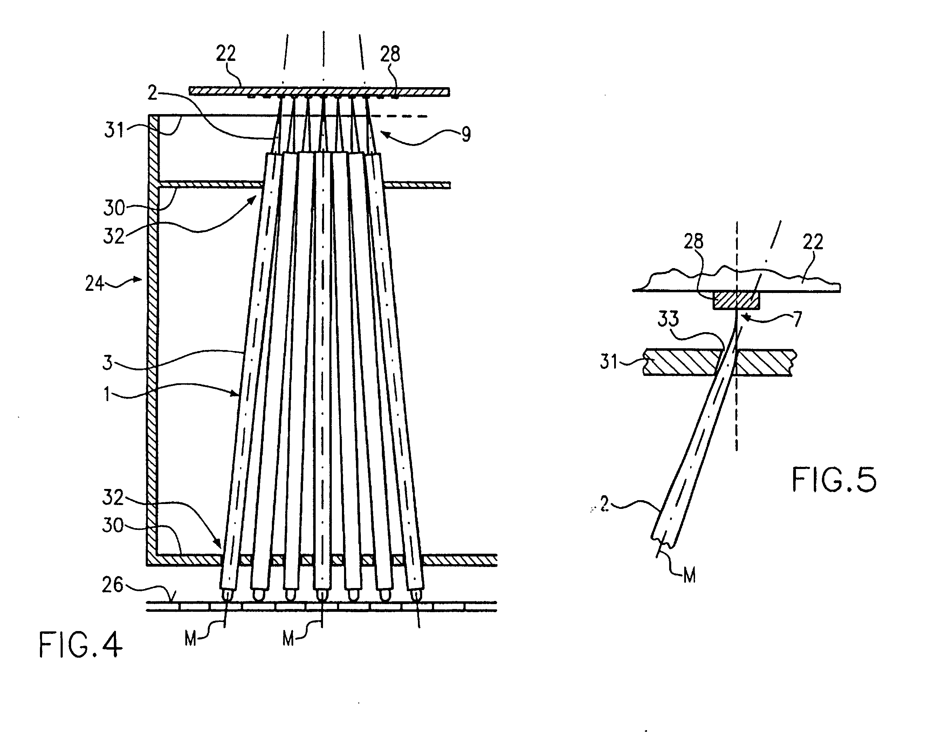

Diese Beschränkungen müssen bei der Festlegung der Maße der erfindungsgemäßen Prüfnadel 1 auch im weiteren berücksichtigt werden. Sie sind in einer erfindungsgemäßen Vorrichtung jedoch wesentlich geringer als in bekannten Vorrichtungen unter Verwendung von Nadeln nach dem Stand der Technik. Zwar hat das Grundrasterfeld 26 der Prüfvorrichtung erheblichen Einfluß auf die räumliche Anordnung der Prüfstifte 1, und da die Prüfstifte 1 in dem Adapter nicht beliebig schräg gestellt und gedreht werden können, auch auf den minimalen Abstand der Prüfspitzen, da sich die Prüfstifte sonst berühren könnten. Wie in der Ausschnittsvergrößerung von Fig. 3 (Fig. 4) dargestellt ist kann in einem erfindungsgemäßen Adapter 24 eine bestimmte reduzierte Steifigkeit bzw. Flexibilität der Kontaktspitze 7 schräggestellter Nadeln 2 genutzt werden, um die jeweiligen Kontaktspitzen 7 durch die benachbart zum Prüfling angeordnete Lage 31 aus ihrer jeweiligen Mittelachse M heraus durch reversibles Biegen abzulenken. Damit können Kontaktspitzen 7 noch näher nebeneinander angeordnete Leiterplatten-Prüfpunkte sicher und ohne elektrisch leitende Berührung untereinander kontaktieren, als dies nach dem Stand der Technik möglich ist. Insbesondere stehen die Kontaktspitzen 7 im wesentlichen senkrecht auf den jeweils zu kontaktierenden Leiterplatten-Prüfpunkten 28, so daß durch die beschriebene Anordnung zuverlässigere elektrische Verbindungen hergestellt werden.

Es ist besonders darauf hinzuweisen, daß die Herstellung von Lagen 30, 31 in einem Adapter 24 einen sehr wesentlichen Kostenfaktor im Bezug auf die Herstellungskosten einer gesamten Prüfvorrichtung darstellt, da das Bohrmuster jeder Lage 30,31 des Adapters 24 mit einem Computer gesondert berechnet und von CNC-gesteuerten Präzisionsmaschinen mit einem individuellen Lochraster 32 gebohrt werden muß. In einem erfindungsgemäßen Adapter 24 werden durch den Einsatz vorstehend beschriebener erfindungsgemäßer Prüfstifte 1 mit Hülsen 3 aufgrund der erhöhten Eigensteifigkeit der erfindungsgemäßen Prüfstifte 1 im Vergleich zu bekannten Nadeln wenige Lagen 30,31 benötigt.

Insbesondere kann der erfindungsgemäße Adapter 24 sowohl eine Vollrasterkassette mit federnden Stiften als auch einen Starmadeladapter zur Anpassung von einem regelmäßigen Raster üblicher Grundrasterfelder hin zu einem beliebigen Raster eines Prüflings, ersetzen, wodurch an einer Prüfvorrichtung ein vollständiges Bauteil ― Vollrasterkassette bzw. Rasteranpassungsadapter - eingespart werden kann.

### Bezugszeichenliste

- R: Rasteranpassungsadapter
- G: Grundrasterfeldes
- T: Leiterplattentestpunkte
- P: zu testende Leiterplatte
- F: Führungslage
- N: Prüfnadeln, starr
- V: Vollrasterkassette
- S: federnder Stift

- 1: Prüfstift
- 2: Nadel
- 3: Hülse
- 4: Feder
- 5: Führungsbereich
- 6: Außenbereich
- 7: Kontaktspitze
- 8: Basisbereich
- 9: Kontaktbereich
10
- 12: Endabschnitt des Kontaktbereiches 9
13

- D: Innendurchmesser der Hülse 3
- d1: Außendurchmesser der Nadel 2 im Außenbereich 6 / Kontaktbereich 9
- d2: Außendurchmesser der Nadel 2 im Führungsbereich 5 / Basisbereich 8
- d: Durchmesser der Kontaktspitze 7
- I1: Länge des Kontaktbereiches
- I2: Länge des Basisbereiches
- l: Länge der Nadel 2
- L: Länge der Hülse 3
- M: Mittelachse der Nadel 2
- 14: Endabschnitt des Basisbereichs 8 der Nadel 2
- 15: Laser-Einschnitte
- 16: Einprägung
- 18: Endbereich der Feder 4
- 20: (federnder) Kontakt

- 22: Leiterplatte/Prüfling
- 24: Adapter
- 26: Grundrasterfeld
- 28: Leiterplatten-Prüfpunkt
- 30: Lage des Adapters
- 31: Lage des Adapters, dem Prüfling zugewandt
- 32: Lochraster
- 33: Ausnehmung

## Patentansprüche

1. Prüfstift für eine Vorrichtung zum Testen von Leiterplatten, mit
einer Nadel (2) und
einer Hülse (3) mit einer Hülseninnenwandung, wobei
die Nadel (2) mit ihrer Außenfläche an der Hülseninnenwandung anliegt und in der Hülse (3) verschieblich geführt ist und
in der Hülse (3) eine Feder (4) vorgesehen ist, die einer Bewegung der Nadel (2) entgegenwirkt, wobei
die Nadel (2) mindestens 10 mm, insbesondere mehr als 20 mm, aus der Hülse (3) herausragt, und einen Durchmesser (d2) von maximal 0,30 mm aufweist, und die Nadel (2) an dem aus der Hülse (3) herausragenden Bereich sich bis zu einer Kontaktspitze (7) hin konisch verjüngt.

2. Prüfstift nach Anspruch 1,
**dadurch gekennzeichnet,**
**daß** die Nadel (2) einen Durchmesser d2 > 0,15 mm aufweist.

3. Prüfstift nach einem oder mehreren der vorhergehenden Ansprüche,
**dadurch gekennzeichnet,**
**daß** die Hülse (3) rohrförmig ausgebildet und
in ihrem Innendurchmesser (D) einem konstanten Außendurchmesser (d1, d2) der Nadel (2) angepaßt ist und
die Nadel (2) sich von dem Übergang eines Basisbereichs (8) zu einem Kontaktbereich (9) an bis zu einer Kontaktspitze (7) hin konisch verjüngt.

4. Prüfstift nach einem oder mehreren der vorhergehenden Ansprüche,
**dadurch gekennzeichnet,**
**daß** die Kontaktspitze einen Durchmesser (d) von ≤ 0,2 mm besitzt und daß ein der Kontaktspitze (7) gegenüberliegender Endbereich des Kontaktbereichs (9) einen um mindestens 0,1 mm größeren Durchmesser (d2) als die Kontaktspitze (7) aufweist.

5. Prüfstift nach Anspruch 3 oder 4,
**dadurch gekennzeichnet,**
**daß** der Basisbereich (8) mindestens eine Länge (J1) von 30 mm besitzt.

6. Prüfstift nach einem oder mehreren der vorhergehenden Ansprüche,
**dadurch gekennzeichnet,**
**daß** die Feder (4) aus einem in der Hülse (3) gelagerten Führungsbereich (5) der Nadel (2), an dem der der Kontaktspitze (7) gegenüberliegenden Ende, herausgeformt und insbesondere durch Lasern in der Form von Laser-Einschnitten (15) herausgearbeitet ist.

7. Prüfstift nach Anspruch 6,
**dadurch gekennzeichnet,**
**daß** die Feder (4) aus einem Teil des Führungsbereichs (5) der Nadel (2) durch senkrecht zur Mittelachse (M) oder durch in einem Winkel < 90° zu der Mittelachse (M) stehenden Einschnitten (15) als insbesondere Mäander- oder Spiralförmiges Teil gebildet ist.

8. Prüfstift nach einem oder mehreren der vorhergehenden Ansprüche 1 bis 5,
**dadurch gekennzeichnet,**
**daß** die Feder (4) an dem Ende des Führungsbereichs (5) der Nadel (2), der der Kontaktspitze (7) gegenüberliegt, mit der Nadel (4) einstückig verbunden und vorzugsweise durch Lasem angeschweißt ist.

9. Prüfstift nach einem oder mehreren der vorhergehenden Ansprüche,
**dadurch gekennzeichnet,**
**daß** der Kontaktbereich (9) bis zu der Kontaktspitze (7) hin in seiner Steifigkeit oder einem ortsabhängigen Verlauf der Steifigkeit festgelegt ist.

10. Prüfstift nach einem oder mehreren der vorhergehenden Ansprüche,
**dadurch gekennzeichnet,**
**daß** die Feder (2) in der Hülse (3) fixiert ist, vorzugsweise durch Quetschen, Falzen und/oder Löten.

11. Adapter mit mindestens zwei im wesentlichen parallelen Lagen (30),
in denen Prüfstifte (1), die nach einem der vorhergehenden Ansprüche ausgebildet sind, in durchgehenden Ausnehmungen (33) gelagert sind, wobei
die Prüfstifte (1) zur Umsetzung eines regelmäßigen Grundrasters eines Grundrasterfeldes (26) auf eine unregelmäßige Anordnung von Leiterplattentestpunkten (28) eines zu testenden Prüflings (22) teilweise schräg angeordnet sind und Kontaktspitzen (7) der Prüfstifte (1) zur Kontaktierung des Prüflings (22) aus dem Adapter herausragen sowie
die Prüfstifte (1) an einer dem Prüfling (22) gegenüberliegenden Seite des Adapters zur Kontaktierung des regelmäßig mit Kontakten versehen Grundrasterfeldes (26) ausgebildet sind.

12. Adapter nach Anspruch 11,
**dadurch gekennzeichnet,**
**daß** die Kontaktspitzen (7) einen Abstand von ca. 0,25 mm und die Kontaktspitzen (7) einen Durchmesser (d) von ca. 0,1 mm aufweisen.

13. Adapter nach Anspruch 11 oder 12,
**dadurch gekennzeichnet,**
**daß** mindestens ein Prüfstift (1) in dem Adapter (24) im Bereich der Kontaktspitze (7) durch mindestens eine Ablenkeinrichtung, insbesondere durch eine Lage (31), aus der Mittelachse (M) des Prüfstiftes (1) heraus abgelenkt, vorzugsweise reversibel gebogen ist.

14. Vorrichtung zum Testen von Leiterplatten mit
einem regelmäßigen Grundrasterfeld (26),
einem Adapter (24) mit mehreren Prüfstiften (1), wobei der Adapter nach einem der Ansprüche 11 bis 13 ausgebildet ist, und
der Adapter (24) an einer ersten Oberseite mit den Prüfstiften (1) in elektrisch leitender Verbindung stehende Kontakte (20) aufweist, die einer Kontaktanordnung auf dem Grundrasterfeld (26) angepaßt sind, und an einer zweiten Oberseite die Kontaktspitzen (7) der Prüfstifte (1) herausragen, wobei jede der Kontaktspitzen (7) einem bestimmten Leiterplatten-Prüfpunkt (28) eines Prüflings (22) zugeordnet ist und bei einem in die Vorrichtung eingelegten Prüfling (22) mit dem Leiterplatten-Prüfpunkt (28) eines Prüflings (22) in elektrisch leitender Berührung steht.

15. Vorrichtung nach Anspruch 14,
**dadurch gekennzeichnet,**
**daß** die Kontaktspitzen (7) an der zweiten Oberseite des Adapters (24) einen Abstand von ≤ 0,3 mm, vorzugsweise von 0,25 mm aufweisen.

16. Vorrichtung nach Anspruch 14 oder 15,
**dadurch gekennzeichnet,**
**daß** mindestens eine Prüfstift (1) in dem Adapter (24) im Bereich der Kontaktspitze (7) durch mindestens eine Ablenkeinrichtung, insbesondere durch eine Lage (31) mit einem Ausnehmungen (33) aufweisenden speziellen Lochraster (32), aus der Mittelachse (M) heraus abgelenkt, vorzugsweise reversibel gebogen ist.

## Claims

1. A probe for a circuit board tester comprising
a needle (2) and
a sleeve (3) with a sleeve inner wall,
said needle (2) being with its outer wall in contact with the sleeve inner wall and being shiftingly guided in said sleeve (3) and
and a spring (4) being provided in said sleeve (3) which counteracts movement of said needle (2)
said needle (2) protruding more than 10 mm, particularly more than 20 mm, from said sleeve (3) and having a maximum diameter (d2) of 0.30 mm, and said needle (2) tapering conically to a contact tip (7) from the area projecting from the sleeve (3).

2. The probe as set forth in claim 1,
**characterized in that**
said needle (2) has a diameter d2 > 0.15 mm.

3. The probe as set forth in one or more of the previous claims,
**characterized in that**
said sleeve (3) is configured tubular and
adapted in its inner diameter (D) to a constant outer diameter (d1, d2) of said needle (2) and
said needle (2) is conically tapered from the transition of a base portion (8) into a contact portion (9) up to said contact tip (7).

4. The probe as set forth in one or more of the previous claims,
**characterized in that**
said contact tip has a diameter (d) of ≤ 0.2 mm and that an end portion of said contact portion (9) opposite said contact tip (7) comprises a diameter (d2) larger by at least 0.1 mm than that of said contact tip (7).

5. The probe as set forth in claim 3 or 4,
**characterized in that**
said base portion (8) has a length (I1) of at least 30 mm.

6. The probe as set forth in one or more of the previous claims,
**characterized in that**
said spring (4) is formed from an end opposite said contact tip (7) of a guide portion (5) of said needle (2) located in said sleeve (3) and is more particularly machined therefrom by laser action in the form of laser incisions (15).

7. The probe as set forth in claim 6,
**characterized in that**
said spring (4) is formed from part of said guide portion (5) of said needle (2) by laser incisions (15) standing perpendicular to the longitudinal centerline or at an angle <90° to said longitudinal centerline as a more particularly meander or spiral-shaped part.

8. The probe as set forth in one or more of the previous claims 1 to 5,
**characterized in that**
said spring (4) at the end of said guide portion (5) of said needle (2) opposite said contact tip (7) is integrally connected to said spring (4) and preferably welded in place by laser application.

9. The probe as set forth in one or more of the previous claims,
**characterized in that**
said contact portion (9) up to said contact tip (7) is defined in its stiffness or in the stiffness profile being a function of the locus.

10. The probe as set forth in one or more of the previous claims,
**characterized in that**
said needle (2) is fixed in place in said sleeve (3), preferably by crimping, folding and/or soldering.

11. An adapter comprising at least two layers (30) in parallel in which probes (1) designed as set forth in any of the previous claims are mounted in through-holes (33), said probes (1) being arranged partly canting and with protruding contact tips (7) of said probes (1) for contacting a test object (22) as well as
said probes (1) on a side of said adapter opposite said test object (22) being configured for contacting a grid pattern array (26) with a regular arrangement of contacts.

12. The adapter as set forth in claim 11,
**characterized in that**
said contact tips (7) comprise a spacing of approx. 0.25 mm and a diameter (d) of approx. 0.1 mm.

13. The adapter as set forth in claim 11 or 12,
**characterized in that**
at least one probe (1) in said adapter (24) in the region of said contact tip (7) is deflected by at least one deflector, more particularly by a layer (31) from the longitudinal centerline (M) of said probe (1), preferably reversibly bent.

14. A circuit board tester comprising
a regular grid pattern array (26),
an adapter (24) including several probes (1) wherein the adapter is designed as set forth in claims 11 to 13,
said adapter (24) comprising at a first upper side contacts (20) in electrical contact with said probes (1) which are adapted to a contact arrangement on said grid pattern array (26), and said contact tips (7) of said probes (1) protruding from a second upper side, whereby each of said contact tips (7) is assigned to a specific circuit board test point (28) of a test object (22) and is in electrical contact with said circuit board test point (28) of a test object (22) inserted in said tester.

15. The tester as set forth in claim 14,
**characterized in that**
said contact tips (7) at said second upper side of said adapter (24) comprise a spacing of ≤ 0.3 mm, preferably 0.25 mm.

16. The tester as set forth in claim 14 or 15
**characterized in that**
at least one probe (1) in said adapter (24) in the region of said contact tip (7) is deflected by at least one deflector, more particularly by a layer (31) from said longitudinal centerline (M) of said probe (1), preferably reversibly bent.

## Revendications

1. Tige de vérification pour un dispositif destiné à tester des cartes avec
une aiguille (2) et
une douille (3) avec une paroi intérieure de douille ;
l'aiguille (2) étant appliquée avec sa surface extérieure sur la paroi intérieure de douille et la douille (3) est conduite coulissante et
un ressort (4) est prévu dans la douille (3) qui agit contre le mouvement de l'aiguille (2) ; l'aiguille (2) faisant saillie d'au moins 10 mm, notamment plus de 20 mm hors de la douille (3) et présentant un diamètre (d2) d'un maximum de 0,30 mm et l'aiguille (2) se rétrécit de manière conique jusqu'à une pointe de contact (7) dans la zone faisant sailli de la douille (3).

2. Tige de vérification selon la revendication 1,
**caractérisée en ce que**,
l'aiguille (2) présente un diamètre d2 >0,15 mm.

3. Tige de vérification selon une ou plusieurs revendications,
**caractérisée en ce que** la douille (3) a la forme d'un tube et
est adaptée dans son diamètre intérieur (D) à un diamètre extérieur (d1,d2) constant et l'aiguille (2) se rétrécit de manière conique jusqu'à une pointe de contact (7) au passage d'une zone de base (8) vers une zone de contact (9).

4. Tige de vérification selon une ou plusieurs des revendications précédentes,
**caractérisée en ce que**,
la pointe de contact possède un diamètre (d) de ≤ 0,2 mm et **en ce qu'**une zone terminale de la zone de contact (9) située en face de la pointe de contact (7) présente un diamètre (d2) d'au moins 0,1 mm plus grand que la pointe de contact (7).

5. Tige de vérification selon la revendication 3 ou 4,
**caractérisée en ce que**,
la zone de base (8) possède au moins une longueur (J1) de 30 mm.

6. Tige de vérification selon une ou plusieurs des revendications précédentes,
**caractérisée en ce que**,
le ressort (4) est réalisé à partir d'une zone de conduite (5) située dans la douille (3) de l'aiguille sur l'extrémité opposée à la pointe de contact (7) et est mis en relief notamment par des rayons laser sous la forme de coupes (15) de laser.

7. Tige de vérification selon la revendication 6,
**caractérisée en ce que**,
le ressort (4) est formé d'une partie de la zone de conduite (5) de l'aiguille (2) par des coupes (15) situés de manière perpendiculaire par rapport à l'axe médian (M) ou selon un angle < 90° par rapport à l'axe médian (M), notamment d'une partie en forme de méandre ou en forme de spirale .

8. Tige de vérification selon une ou plusieurs des revendications précédentes 1 à 5,
**caractérisée en ce que**,
le ressort (4) est relié de façon solidaire avec l'aiguille (4) sur l'extrémité de la zone de conduite (5) qui se trouve en face de la pointe de contact (7) et est soudé de préférence par laser.

9. Tige de vérification selon une ou plusieurs des revendications précédentes,
**caractérisée en ce que**,
la zone de contact (9) est fixée en fonction du lieu jusqu'à la pointe de contact (7) dans sa rigidité ou une extension de la rigidité .

10. Tige de vérification selon une ou plusieurs des revendications précédentes,
**caractérisée en ce que**,
le ressort (2) est fixé dans la douille (3), de préférence par pressage , pliage et / ou soudage.

11. Adaptateur avec au moins deux couches (30) essentiellement parallèles, dans lesquelles des tiges de vérification (1) formées selon une des revendications précédentes, sont logées dans des évidements continus ; les tiges de vérification (1) étant disposées en partie en biais pour réaliser une grille de base régulière d'un champ de grille de base (26) sur une disposition irrégulière de points de vérification de carte (28) d'un échantillon (22) à tester et des pointes de contact (7) des tiges de vérification (1) pour le contact des échantillons (22) faisant saillie hors de l'adaptateur ainsi
les tiges de vérification (1) étant formées sur un des côtés situés en face de l'échantillon (22) de l'adaptateur pour contacter le champ de grille de base (26) pourvu régulièrement de contacts .

12. Adaptateur selon la revendication 11,
**caractérisé en ce que**,
les pointes de contact (7) présentent un espace d'environ 0,25 mm et les pointes de contact (7) un diamètre (d) d'environ 0,1 mm.

13. Adaptateur selon la revendication 11 ou 12,
**caractérisé en ce que**,
au moins une tige de vérification (1) est déviée dans l'adaptateur (24) dans la zone de la pointe de contact (7) par au moins un dispositif de déviation , notamment par une couche (31) hors de l'axe médian (M) de la tige de vérification (1), de préférence courbée de manière réversible.

14. Dispositif pour tester des cartes avec
un champ de grille de base (26) régulier,
un adaptateur (24) avec plusieurs tiges de vérification (1) ; l'adaptateur étant formé selon une des revendications 11 à 13, et
un adaptateur (24) qui présente sur un premier côté supérieur des contacts se trouvant dans une liaison de conduite électrique avec les tiges de vérification (1), lesquels contacts sont adaptés à une disposition de contact sur le champ de grille de base (26) et les pointes de contact (7) des tiges de vérification (1) font saillie sur le deuxième côté supérieur ; chacune des pointes de contact (7) étant associée à un point de vérification (28) des cartes déterminé d'un échantillon (22) et restant dans un contact conducteur d'électricité avec un échantillon (22) disposés dans le dispositif avec un point de vérification (28) des cartes d'un échantillon (22).

15. Dispositif selon la revendication 14,
**caractérisé en ce que**,
les pointes de contact (7) présentent sur le deuxième côté supérieur de l'adaptateur (24) une distance de ≤ 0,3 mm, de préférence de 0,25 mm.

16. Dispositif selon la revendication 14 ou 15,
**caractérisé en ce que**,
au moins une tige de vérification (1) est déviée dans l'adaptateur (24) dans la zone de la pointe de contact (7) par au moins un dispositif de déviation , notamment par une couche (31) avec une grille de trous (32) spéciale comportant des évidements (33), hors de l'axe médian (M) de la tige de vérification (1), de préférence courbée de manière réversible.
